# EUROPEAN PATENT APPLICATION

(11) **EP 4 386 851 A1**
(43) Date of publication of application: **19.06.2024**
(21) Application number: 23200754.2
(22) Date of filing: 29.09.2023
(51) Int. Cl.: H01L 29/06, H01L 29/08, H01L 29/417, H01L 29/423, H01L 29/66, H01L 29/775, H01L 29/10, H01L 29/161

(54) **EPITAXIAL SOURCE OR DRAIN REGION WITH A WRAPPED CONDUCTIVE CONTACT**

(30) Priority: 16.12.2022 US 202218082851
(71) Applicant: INTEL Corporation, Santa Clara, CA 95054 (US)
(72) Inventor: JUN, Hwichan, Portland, 97229 (US)
(74) Representative: 2SPL Patentanwälte PartG mbB

(57) **Abstract**

Techniques are provided herein to form semiconductor devices having one or more epitaxial source or drain regions wrapped by a conductive contact to form an improved ohmic contact. A first semiconductor device includes a first semiconductor region extending between a first source or drain region and a second source or drain region, and a second semiconductor device includes a second semiconductor region extending between the first source or drain region and a third source or drain region. The first and second semiconductor devices include a subfin region adjacent to a dielectric layer. A conductive layer extends around the first source or drain region such that the conductive layer at least contacts the sidewalls of the first source or drain region and both upper and lower surfaces of the source or drain region. A dielectric layer is also present between the conductive contact and the subfin region.

## Description

### FIELD OF THE DISCLOSURE

The present disclosure relates to integrated circuits, and more particularly, to the epitaxial region contact formation for transistor devices.

### BACKGROUND

As integrated circuits continue to scale downward in size, a number of challenges arise. For instance, reducing the size of memory and logic cells is becoming increasingly more difficult. Providing contacts to the various transistor structures presents a challenge as the devices continue to scale downward. Having a good ohmic contact to the source or drain regions of a device is important for a robust operation, yet providing a good ohmic contact to each source or drain region across an integrated circuit can be difficult. Accordingly, there remain a number of non-trivial challenges with respect to semiconductor source or drain contact formation.

### BRIEF DESCRIPTION OF THE DRAWINGS

Figures 1A and 1B are cross-sectional views of an integrated circuit configured with a conductive contact wrapped around an epitaxial region, in accordance with some embodiments of the present disclosure.
Figures 2A and 2B are cross-sectional views that illustrate one stage in an example process for forming an integrated circuit having a conductive contact wrapped around an epitaxial region, in accordance with an embodiment of the present disclosure.
Figures 3A and 3B are cross-sectional views that illustrate another stage in the example process for forming an integrated circuit having a conductive contact wrapped around an epitaxial region, in accordance with an embodiment of the present disclosure.
Figures 4A and 4B are cross-sectional views that illustrate another stage in the example process for forming an integrated circuit having a conductive contact wrapped around an epitaxial region, in accordance with an embodiment of the present disclosure.
Figures 5A and 5B are cross-sectional views that illustrate another stage in the example process for forming an integrated circuit having a conductive contact wrapped around an epitaxial region, in accordance with some embodiments of the present disclosure.
Figures 6A and 6B are cross-sectional views that illustrate another stage in the example process for forming an integrated circuit having a conductive contact wrapped around an epitaxial region, in accordance with an embodiment of the present disclosure.
Figures 7A and 7B are cross-sectional views that illustrate another stage in the example process for forming an integrated circuit having a conductive contact wrapped around an epitaxial region, in accordance with an embodiment of the present disclosure.
Figures 8A and 8B are cross-sectional views that illustrate another stage in the example process for forming an integrated circuit having a conductive contact wrapped around an epitaxial region, in accordance with an embodiment of the present disclosure.
Figures 9A and 9B are cross-sectional views that illustrate another stage in the example process for forming an integrated circuit having a conductive contact wrapped around an epitaxial region, in accordance with an embodiment of the present disclosure.
Figures 10A and 10B are cross-sectional views that illustrate another stage in the example process for forming an integrated circuit having a conductive contact wrapped around an epitaxial region, in accordance with an embodiment of the present disclosure.
Figures 11A and 11B are cross-sectional views that illustrate another stage in the example process for forming an integrated circuit having a conductive contact wrapped around an epitaxial region, in accordance with an embodiment of the present disclosure.
Figures 12A and 12B are cross-sectional views that illustrate another stage in the example process for forming an integrated circuit having a conductive contact wrapped around an epitaxial region, in accordance with an embodiment of the present disclosure.
Figures 13A and 13B are cross-sectional views that illustrate another stage in the example process for forming an integrated circuit having a conductive contact wrapped around an epitaxial region, in accordance with an embodiment of the present disclosure.
Figures 14A and 14B are cross-sectional views that illustrate another stage in the example process for forming an integrated circuit having a conductive contact wrapped around an epitaxial region, in accordance with some embodiments of the present disclosure.
Figure 15 illustrates a cross-section view of a chip package containing one or more semiconductor dies, in accordance with some embodiments of the present disclosure.
Figure 16 is a flowchart of a fabrication process for semiconductor device having a conductive contact wrapped around an epitaxial region, in accordance with an embodiment of the present disclosure.
Figure 17 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices having one or more epitaxial source or drain regions wrapped by a conductive contact to form an improved ohmic contact. The techniques can be used in any number of integrated circuit applications and are particularly useful with respect to logic and memory cells, such as those cells that use finFETs or gate-all-around transistors. In an example, a first semiconductor device includes a first semiconductor region, such as one or more first nanoribbons, extending between a first source or drain region and a second source or drain region, and a second semiconductor device includes a second semiconductor region, such as one or more second nanoribbons, extending between the first source or drain region and a third source or drain region. Each of the first and second semiconductor devices also include subfin regions adjacent to a dielectric layer that extends between the first and second semiconductor devices. A conductive layer extends around the first source or drain region such that the conductive layer at least contacts the sidewalls of the first source or drain region and both upper and lower surfaces of the source or drain region. A dielectric layer may be present between the conductive contact and the subfin region beneath the first source or drain region. In some other examples, the subfin region is at least partially removed and a backside contact is present on the backside surface of the conductive contact. Some such cases include a backside interconnect structure which may route signal or power to or from the conductive contact by the backside contact. In any such cases, by forming a conductive contact around multiple sides of the source or drain region (rather than just contacting a top or bottom surface) more surface area of the source or drain region is contacted thus providing an improved ohmic contact and a lower overall contact resistance. Numerous variations and embodiments will be apparent in light of this disclosure.

### General Overview

As previously noted above, there remain a number of non-trivial challenges with respect to epitaxial contact formation. Epitaxial contacts may be formed along the top surface of the source or drain regions for frontside contacts or formed on the bottom surface of the source or drain regions for backside contacts. However, such contacts do not leverage the total surface area present along the entire outside surface of the source or drain regions, especially along the sidewalls of the epitaxially grown regions. Although silicide growth on the epitaxial regions can be used to enhance the ohmic contact, such growth is limited to the areas of the source or drain region that can be exposed from the top or bottom, and thus also do not leverage the sidewalls of the source or drain region.

Thus, and in accordance with an embodiment of the present disclosure, techniques are provided herein to form epitaxial contact structures that provide a better ohmic contact with a lower overall contact resistance to the source and/or drain regions, or other epitaxial diffusion region(s). The contacts are formed in such a way that they wrap around the source or drain regions, thus contacting the sidewalls to provide an enhanced ohmic contact. The epitaxial source or drain region may also include a highly conductive outer layer, such as a silicide layer, that extends around all outside edges of the source or drain region to provide a better ohmic contact with the conductive material (e.g., a metal) of the contact. The metal contact may extend along all surfaces of a source or drain region such that the contact wraps completely around the source or drain region or at least wraps around the sidewalls of the source or drain region. As used herein, the term "along" means that a structure is closely adjacent to (e.g., within 20 nm of) and runs in the same direction (e.g., parallel to) another structure. For example, a layer that is along a sidewall of a gate runs in the same direction to the gate sidewall and is within 20 nm of the sidewall of the gate. Additionally, a layer can be along a structure without being directly on the structure such that one or more intervening layers could exist between the layer and the structure.

According to an embodiment, an integrated circuit includes a semiconductor device having a subfin and one or more semiconductor nanoribbons extending in a first direction from a source or drain region, a conductive layer that extends completely around the source or drain region, and a dielectric layer on a top surface of the subfin, such that the dielectric layer is between the subfin and the conductive layer. The subfin extends beneath the conductive layer.

According to another embodiment, a method of forming an integrated circuit includes forming a multilayer fin extending in a first direction over a substrate having a first section with first material layers alternating with second material layers, and a subfin section beneath the first section; forming a dielectric fill adjacent to the subfin section; forming a sacrificial gate and spacers on sidewalls of the sacrificial gate, the sacrificial gate extending in a second direction over the multilayer fin, the second direction being different from the first direction; removing an exposed portion of the multilayer fin adjacent to the sacrificial gate, the removing exposing a top surface of the subfin; forming a dielectric layer on the top surface of the subfin and on a top surface of the adjacent dielectric fill; forming a sacrificial layer on the dielectric layer; forming a source or drain region over the sacrificial layer and coupled to ends of the second material layers; forming a sacrificial material around the source or drain region and over the sacrificial layer; removing the sacrificial gate and forming a gate structure over the first material layers; removing the sacrificial layer and the sacrificial material and forming a conductive layer completely around the source or drain region; and forming one or more dielectric plugs through an entire thickness of the conductive layer.

The techniques can be used with any type of non-planar transistors, including finFETs (sometimes called double-gate transistors, or tri-gate transistors), or nanowire, nanosheet, and nanoribbon transistors (sometimes called gate-all-around transistors), to name a few examples. The source and drain regions can be, for example, epitaxial regions that are deposited during an etch-and-replace source/drain forming process. The dopant-type in the source and drain regions will depend on the polarity of the corresponding transistor. The source and drain regions may be any epitaxial diffusion region. The gate structure can be implemented with a gate-first process or a gate-last process (sometimes called a remove metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of a conductive contact material around multiple sides of a diffusion region (e.g., source or drain region), such as at least along the sidewalls of the diffusion region. In some embodiments, the conductive contact material completely wraps around the diffusion region. A dielectric layer may be observed between the conductive contact and a subfin region beneath the conductive contact. In some cases, a backside contact may be provided on the bottom surface of the conductive contact, with the backside contact effectively breaking through the dielectric layer so that it touches the bottom surface of the wrap-around conductive contact. In any such cases, the conductive contact may be adjacent one or two dielectric structures (e.g., plug or wall) and have an inverse taper, such that the width at the top surface of the conductive contact is narrower than the width at the bottom surface of the conductive contact, as visible in a cross-section taken through the source or drain region and perpendicular to the fin. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

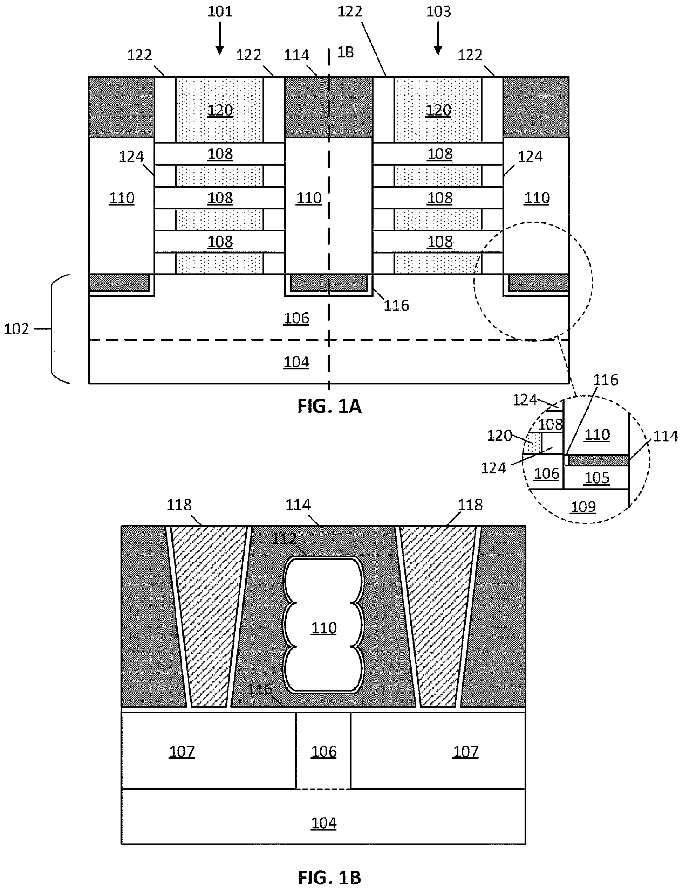

Figures 1A and 1B are cross-sectional views of a portion of an integrated circuit that includes various semiconductor devices, in accordance with an embodiment of the present disclosure. Two such semiconductor devices 101 and 103 are illustrated in Figure 1A. The cross-section in Figure 1B is taken across the vertical dashed line in Figure 1A. Accordingly, the cross-section view in Figure 1B illustrates an adjacent source or drain region formed at the ends of semiconductor devices 101 and 103. Each of the semiconductor devices may be non-planar metal oxide semiconductor (MOS) transistors, such as tri-gate or gate-all-around transistors, although other transistor topologies and types could also benefit from the techniques provided herein. The examples herein illustrate semiconductor devices with a GAA structure (e.g., having nanoribbons or nanowires that extend between source and drain regions).

The semiconductor material used in each of the semiconductor devices may be formed from a semiconductor substrate 102. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. Substrate 102 may include a bulk region 104 and any number of subfins 106 as seen more clearly in Figure 1B. Each subfin 106 may be formed via etching through a portion of substrate 102 and are aligned beneath corresponding semiconductor devices.

As can further be seen, a dielectric layer 107 extends across a bottom portion of the integrated circuit and between subfins 106 of each of the semiconductor devices, according to an embodiment. Dielectric layer 107 may include any suitable dielectric material such as silicon dioxide. Dielectric layer 107 provides shallow trench isolation (STI) between adjacent semiconductor devices. According to some embodiments, subfins 106 are portions of the semiconductor fins that remain after formation of the various transistors and may be formed from a semiconductor substrate that is later removed to form backside interconnect structures. Accordingly, subfins 106 may include the same semiconductor material as the one or more semiconductor regions of the semiconductor devices.

The one or more semiconductor bodies of semiconductor devices 101 and 103 may include fins that can be, for example, native to the substrate (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires or nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins or deposited into fin-shaped trenches.

In the illustrated example, semiconductor devices 101 and 103 include one or more nanoribbons 108 (e.g., semiconductor regions or bodies) extending between epitaxial source or drain regions 110 in a first direction (e.g., across the page of Figure 1A). Although three nanoribbons 108 are illustrated for each device, it should be understood that the embodiments described herein are applicable to devices having any number of nanoribbons, such as four or more nanoribbons. Source or drain regions 110 may be formed at the ends of nanoribbons 108 of each device, and thus may be aligned adjacent to one another along a second direction different from the first direction as seen in Figure 1B. The second direction may be orthogonal to the first direction (e.g., into and out of the page of Figure 1A). According to some embodiments, source or drain regions 110 are epitaxial regions that are provided on the semiconductor regions in an etch-and-replace process. Any semiconductor materials suitable for source or drain regions can be used (e.g., group IV and group III-V semiconductor materials). Source or drain regions 110 may include multiple layers such as liners and capping layers to improve contact resistance. In any such cases, the composition and doping of source or drain regions 110 may be the same or different, depending on the polarity of the transistors. Any number of source or drain configurations and materials can be used. In some embodiments, a conductive liner 112 may be present along the outer surface of source or drain regions 110, such that conductive liner 112 is present between source or drain regions 110 and a corresponding conductive contact 114. Conductive liner 112 may be a silicide or other highly conductive material, and may be used to further reduce the contact resistance between source or drain region 110 and conductive contact 114. In some embodiments, conductive contact 114 wraps around a portion of source or drain region 110. Conductive contact 114 may be any suitable conductive material such as tungsten. According to some embodiments, a bottom dielectric layer 116 may be provided to form an insulating buffer between conductive contact 114 and subfin 106. Bottom dielectric layer 116 may be any suitable dielectric material, such as silicon dioxide, silicon nitride, or silicon oxynitride.

According to some embodiments, dielectric plugs 118 may extend through an entire thickness of at least conductive contact 114 to provide electrical isolation between contacts along the source/drain trench. Dielectric plugs 118 may be any suitable dielectric material, such as silicon dioxide, silicon nitride, or silicon oxynitride. According to some embodiments, bottom dielectric layer 116 may also be provided beneath dielectric plugs 118 and along sidewalls of dielectric plugs 118. In some examples, a different dielectric layer is on the sidewalls and bottom of dielectric plugs 118 that may or may not have the same material composition as bottom dielectric layer 116. In some embodiments, bottom dielectric layer 116 or the different dielectric layer is a high-k dielectric material, such as silicon nitride, while dielectric plugs 118 includes a low-k dielectric material, such as silicon dioxide.

According to some embodiments, dielectric plugs 118 have a width along the second direction that tapers down as the plugs extend through the thickness of conductive contact 114. This tapering of dielectric plugs 118 gives conductive contact 114 a trapezoidal cross-section along the second direction, according to some embodiments. For example, conductive contact 114 may have a bottom surface (e.g., adjacent to bottom dielectric layer 116) that is wider than a top surface of conductive contact 114. For instance, and as shown in Figure 1B, the forming process of dielectric plugs 118 causes the conductive contact 114 that wraps around diffusion region 110 to have an inverse taper, such that angle A is an acute angle (e.g., 75° to 88°). In some such examples, the width of the top surface of contact 114 is about 2 nm or more narrower than the width of the bottom surface of contact 114. Such an inverted taper is unusual for a contact, as a standard trench-based contact would have a normal taper (wider at top than bottom).

According to some embodiments, semiconductor devices 101 and 103 each include a gate structure 120 having a gate electrode and a gate dielectric extending over the one or more semiconductor regions in the second direction to form transistor gates. A given gate structure may extend over the semiconductor regions of more than one semiconductor device along the second direction.

As noted above, gate structures 120 extend in the second direction over one or more semiconductor regions of various devices and include both a gate electrode and a gate dielectric. The gate electrode may include any sufficiently conductive material such as a metal, metal alloy, or doped polysilicon. In some embodiments, the gate electrode includes one or more workfunction metals around the one or more semiconductor regions. In some embodiments, p-channel devices include a workfunction metal having titanium around its one or more semiconductor regions and n-channel devices include a workfunction metal having tungsten around its one or more semiconductor regions. The gate electrode may also include a fill metal or other conductive material around the workfunction metals to provide the whole gate electrode structure. The gate dielectric represents any number of dielectric layers that exist between the one or more semiconductor regions (e.g., nanoribbons 108) and the gate electrode.

According to some embodiments, spacer structures 122 and inner spacers 124 are present on the sidewalls of gate structures 120 and define a gate trench through which gate structures 120 are formed. Each of spacer structures 122 and inner spacers 124 may include any suitable dielectric material such as silicon nitride or silicon oxynitride.

In some embodiments, after frontside processing is done, the structure can be inverted to allow for backside processing where bulk region 104 of substrate 102, and possibly some or all of subfin region 106, may be removed and replaced with a conductive material to facilitate a backside interconnect scheme. One such example is shown in the alternative embodiment within the dashed circle of Figure 1A. In this case, bulk region 104 has been removed and replaced with an interconnect layer 109, and a backside contact 105 is coupled between the bottom surface of contact 114 and interconnect layer 109. Interconnect layer 109 may include a dielectric material and any number of interconnect features, such as conductive vias and conductive lines which can route signal or power to or from contact 114 by way of backside contact 105. Any number of such interconnect layers may be provided within an overall backside interconnect structure, with an etch stop layer between each interconnect layer. In this particular example, a portion of dielectric layer 116 remains adjacent to a top surface of backside contact 105.

### Fabrication Methodology

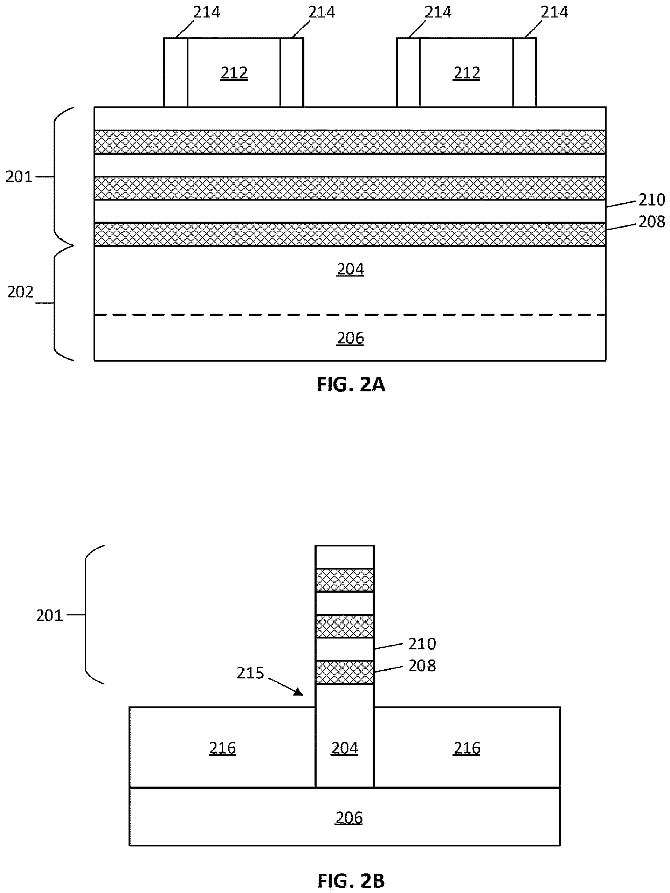

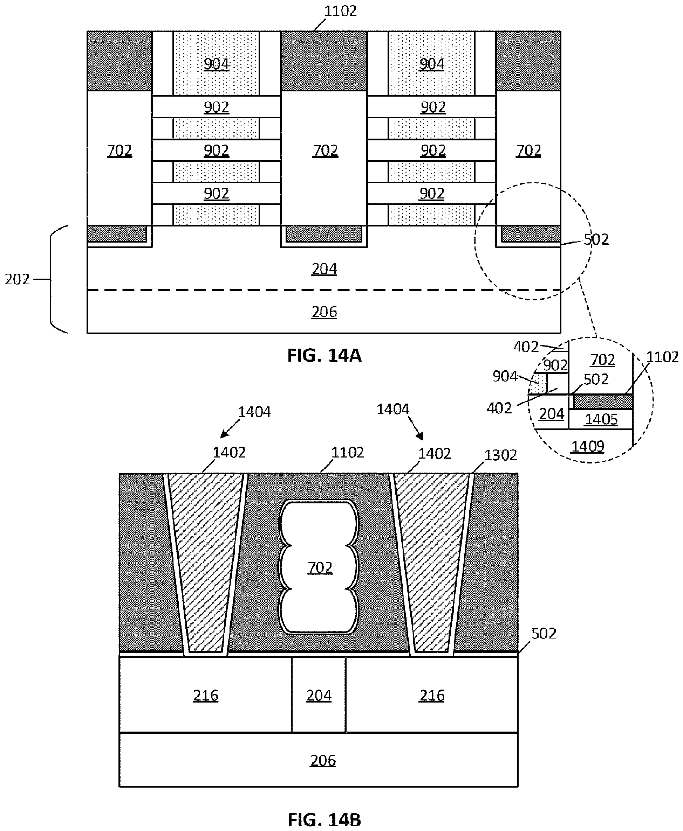

Figures 2A - 14A and 2B - 14B are cross-sectional views that collectively illustrate an example process for forming an integrated circuit configured with a multi-layer spacer structure, in accordance with an embodiment of the present disclosure. Figures 2A - 14A represent a cross-sectional view taken across the first direction as seen in Figure 1A, while figures 2B - 14B represent a cross-sectional view taken across the second direction as seen in Figure 1B. Each figure shows an example structure that results from the process flow up to that point in time, so the depicted structure evolves as the process flow continues, culminating in the structure shown in Figures 14A and 14B, which is similar to the structure shown in Figures 1A and 1B, respectively. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but the present disclosure is not intended to be limited to any specific such materials or parameters, as will be appreciated. Figures sharing the same number (e.g., Figures 2A and 2B) illustrate different views of the structure at the same point in time during the process flow.

Figures 2A and 2B illustrate cross-sectional views taken through and parallel to a fin 201 of one of the semiconductor devices (Figure 2A) formed over a semiconductor substrate 202 and taken across the area where the source or drain region will be that is perpendicular to a length of fin 201 (Figure 2B). In this example, fin 201 includes alternating layers of material in order to ultimately form nanowires or nanoribbons in a gate-all-around (GAA) structure. In other examples, fin 201 includes a single semiconductor material (e.g., silicon or germanium).

Substrate 202 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 202 can be a semiconductor-on-insulator substrate having a desired semiconductor layer over a buried insulator layer (e.g., silicon over silicon dioxide). Alternatively, substrate 202 can be a multilayer substrate or superlattice suitable for forming nanowires or nanoribbons (e.g., alternating layers of silicon and SiGe, or alternating layers indium gallium arsenide and indium phosphide). Any number of substrates can be used. Substrate 202 may include a subfin 204 and a bulk region 206 as seen more clearly in Figure 2B.

In this example, fin 201 includes alternating layers of sacrificial layers 208 and semiconductor layers 210. Semiconductor layers 210 may include silicon, germanium, or an alloy thereof. Sacrificial layers 208 have a different material composition than semiconductor layers 210. In some embodiments, sacrificial layers 208 include some combination of silicon and germanium.

As seen in Figure 2A, one or more sacrificial gates 212 are patterned over fin 201 and run in an orthogonal direction to a length of fin 201. Sacrificial gate 212 may include any material that can be safely removed later in the process without etching or otherwise damaging the sidewall spacers 214 and/or fin 201. Sidewall spacers 214 may be formed on sidewalls of sacrificial gate 212 and can include any suitable dielectric material, such as silicon nitride. Some portion of sidewall spacers 214 may also develop on the sidewalls of fin 201, according to some embodiments.

As seen in Figure 2B, fin 201 extends above a dielectric fill 216 that acts as an STI region between adjacent fins (other fins are not shown for clarity). Dielectric fill 216 may include silicon dioxide. According to some embodiments, dielectric fill 216 may be recessed below a top surface of subfin 204, such that a top portion 215 of subfin 204 is exposed above dielectric fill 216. Subfin 204 may include the same material as bulk region 206 of substrate 202.

While dimensions can vary from one example embodiment to the next, in one example case, the total height of fin 201 may be between 50 nm and 150 nm, and the width of fin 201 can be, for example, in the range of 5 to 100 nm. The thickness of each of semiconductor layer 210 and sacrificial layer 208 may be between about 5 nm and about 25 nm.

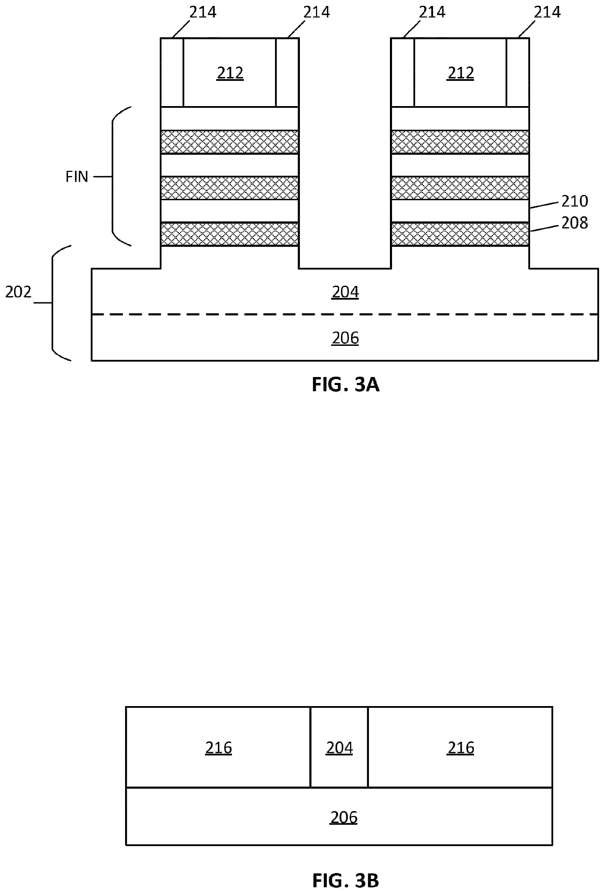

Figures 3A and 3B depict the cross-section views of the structure shown in Figures 2A and 2B, respectively, following the removal of the exposed fin not under sacrificial gate 212 and sidewall spacers 214. According to some embodiments, both semiconductor layers 210 and sacrificial layers 208 are etched using an anisotropic RIE process. As observed in Figure 3A, the width of sidewall spacers 214 works to define the length of each fin that defines each semiconductor device. In some embodiments, some undercutting occurs along the edges of the fins beneath sidewall spacers 214 such that the length is not exactly the same as a sum of the widths of sidewall spacers 214 and a width of sacrificial gate 212. As observed in Figure 3B, the fin is completely removed above subfin 204. In some embodiments, the RIE process also etched into a portion of subfin 204 thus recessing subfin 204 until it is substantially coplanar with a top surface of dielectric fill 216 (as shown in Figure 3B). In some embodiments, subfin 204 is recessed below the top surface of dielectric fill 216. Other materials adj acent to or directly on the fin may also be removed, such as portions of sidewall spacers 214, in the view depicted in Figure 3B.

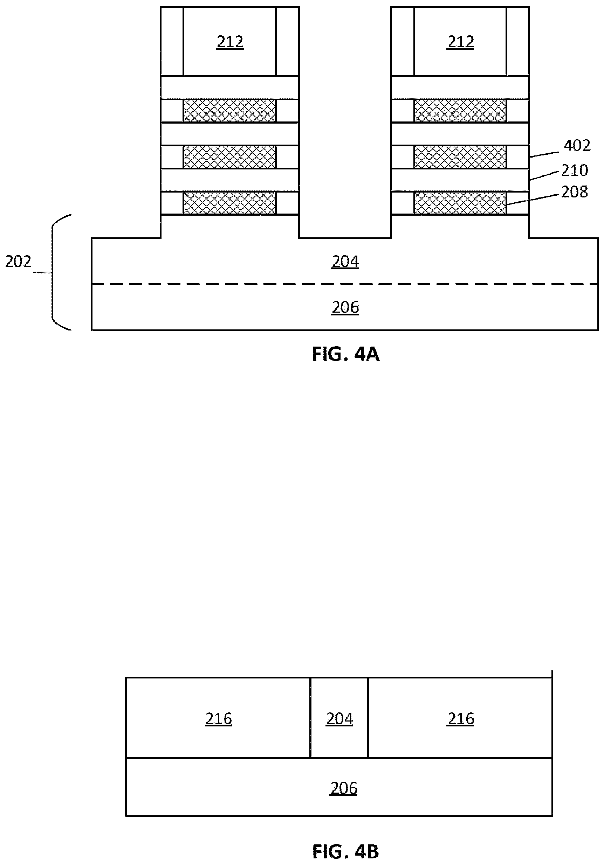

Figures 4A and 4B depict the cross-section views of the structure shown in Figures 3A and 3B, respectively, following the formation of inner spacers 402. According to some embodiments, prior to the formation of inner spacers 402, the exposed ends of sacrificial layers 208 are laterally recessed using an isotropic etching process that selectively etches sacrificial layers 208 as opposed to semiconductor layers 210. Afterwards, a dielectric layer is deposited to effectively fill the dimples between semiconductor layers 210, according to some embodiments. The dielectric layer can then be etched back using RIE or a wet isotropic etch at least until the ends of semiconductor layers 210 are exposed, however, the dielectric layer remains as inner spacers 402 around portions of semiconductor layers 210 near its ends.

According to some embodiments, inner spacers 402 has the same material composition as sidewall spacers 214. It should be noted that inner spacers 402 may only be present when using a gate-all-around (GAA) structure having semiconductor nanoribbons or nanowires.

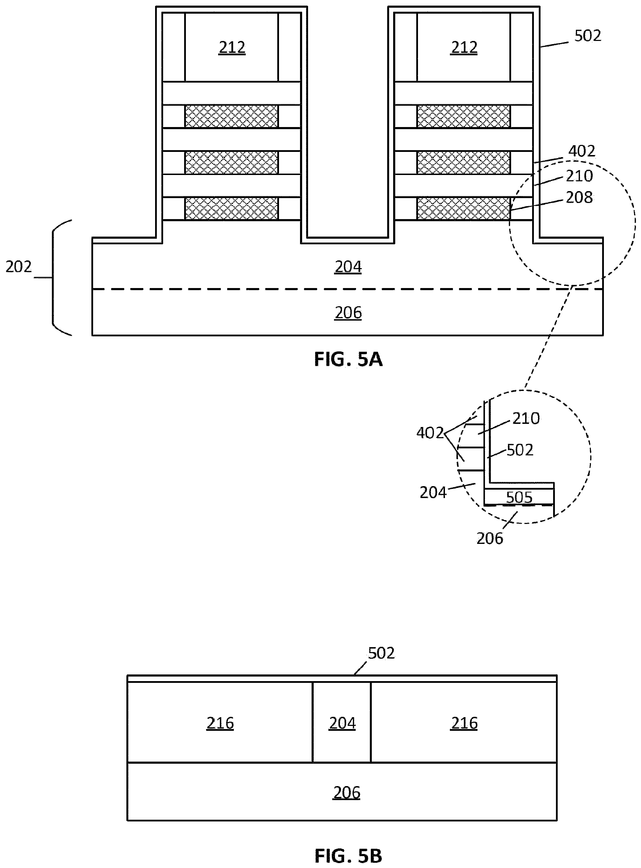

Figures 5A and 5B depict the cross-section views of the structure shown in Figures 4A and 4B, respectively, following the formation of a dielectric layer 502 over the entire structure. According to some embodiments, dielectric layer 502 may include a high-k dielectric material (e.g., having a dielectric constant greater than 6.5), such as silicon nitride. In some embodiments, dielectric layer 502 may include any dielectric material having a high etch selectivity compared to the dielectric material (e.g., silicon dioxide) of dielectric fill 216. Dielectric layer 502 may be deposited using atomic layer deposition (ALD) to thickness between about 1 nm and about 5 nm.

In some embodiments, a place holder for a backside contact can be provisioned after the diffusion trench is etched and before dielectric layer 502 is deposited. One such example is shown in the alternative embodiment within the dashed circle of Figure 5A. In this case, the diffusion etch is extended so that it goes deeper into the underlying subfin region. Then, a place holder 505 is deposited and recessed as shown. Dielectric layer 502 can then be deposited (or re-deposited if need be). Place holder 505 can be any material (e.g., titanium nitride) that can later be selectively removed during a backside contact forming process, such as shown in Figure 14A.

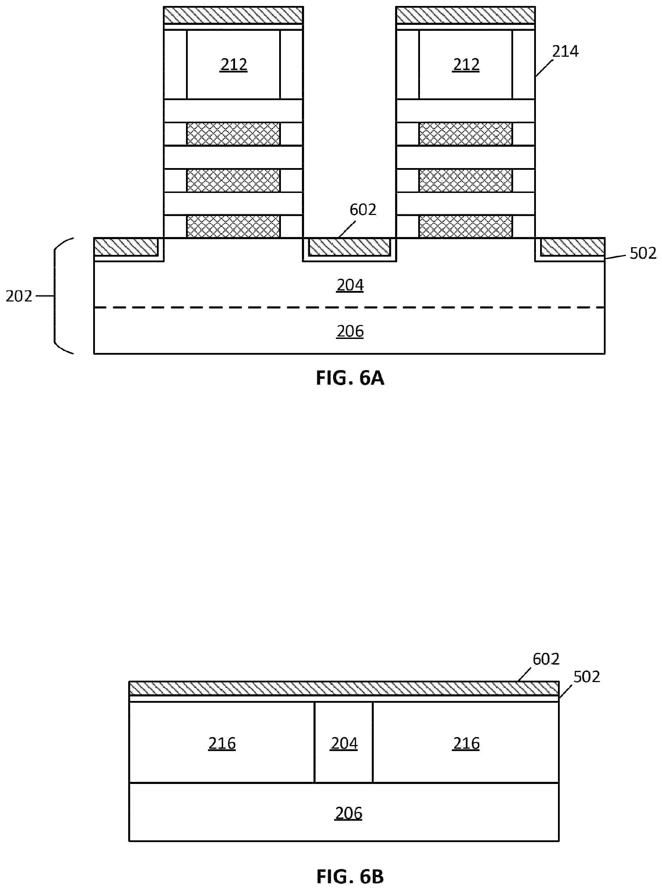

Figures 6A and 6B depict the cross-section views of the structure shown in Figures 5A and 5B, respectively, following the formation of a mask layer 602 and subsequent removal of exposed portions of dielectric layer 502. According to some embodiments, mask layer 602 may be deposited using a directional (e.g., non-conformal) technique such as physical vapor deposition (PVD) to form primarily at the bottom of the source/drain trenches and on the tops of sacrificial gates 212 and sidewall spacers 214. Mask layer 602 may be any dielectric material or other hard mask material having a high etch selectively compared to the material of dielectric layer 502. For example, mask layer 602 may be silicon dioxide while dielectric layer 502 is silicon nitride or vice-versa. Once mask layer 602 has been deposited, the exposed portions of dielectric layer 502 along the sidewalls of the semiconductor structures may be removed using any suitable isotropic etching process.

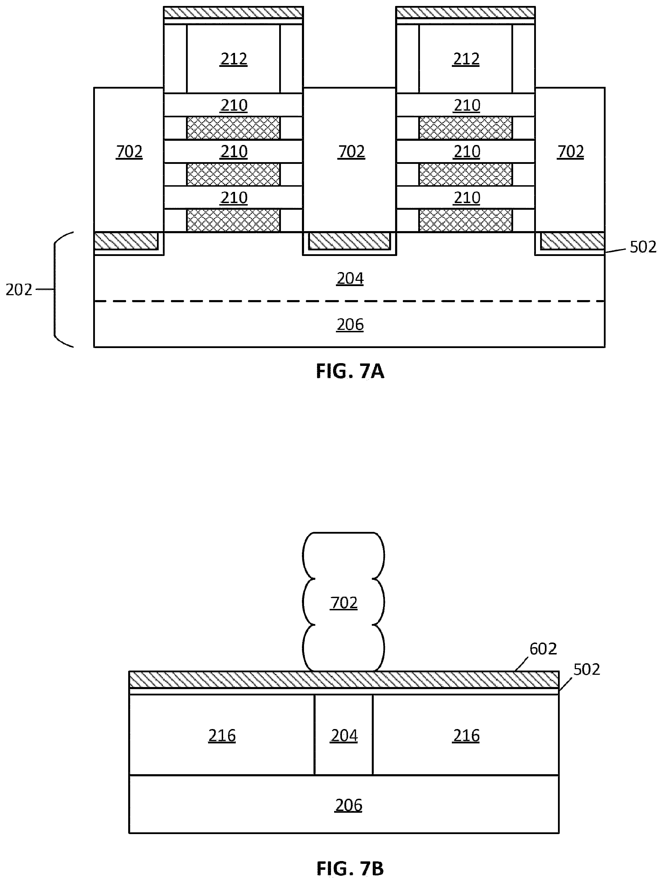

Figures 7A and 7B depict the cross-section views of the structure shown in Figures 6A and 6B, respectively, following the formation of source or drain region 702 between the fins, according to some embodiments. Source or drain region 702 may be epitaxially grown from the exposed ends of semiconductor layers 210, such that the material grows together or otherwise merges towards the middle of the trench between the fins, according to some embodiments. In other embodiments, the epitaxial growth may only partially merge, or not merge at all thereby leaving space between the laterally adjacent epi-growths in which contact material can be deposited. Such embodiments may further increase contact surface area and thus further lower contact resistance. Further note that epitaxial growth on one semiconductor layer 210 can fully or partially merge with epitaxial growth on one or more other semiconductor layers 210 in the same vertical stack. The degree of any such merging can vary from one embodiment to the next. In the example of a PMOS device, source or drain region 702 may be a semiconductor material (e.g., group IV or group III-V semiconductor materials) having a higher dopant concentration of p-type dopants compared to n-type dopants. In the example of an NMOS device, source or drain region 702 may be a semiconductor material (e.g., group IV or group III-V semiconductor materials) having a higher dopant concentration of n-type dopants compared to p-type dopants. As seen in Figure 7B, source or drain region 702 may abut the underlying mask layer 602.

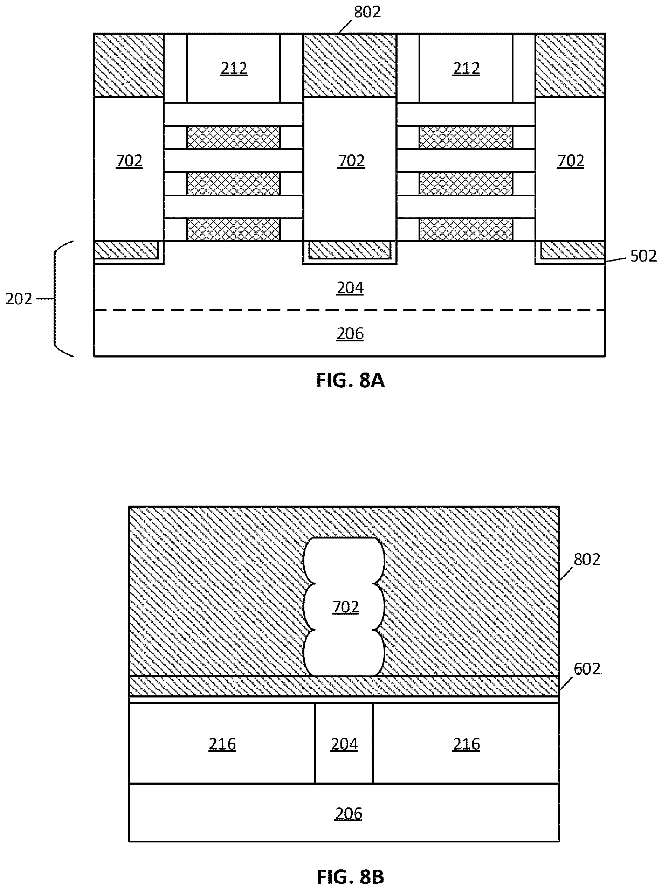

Figures 8A and 8B depict the cross-section views of the structure shown in Figures 7A and 7B, respectively, following the formation of a dielectric fill 802 within the source/drain trench and around source or drain region 702. According to some embodiments, dielectric fill 802 is any suitable dielectric material. In some examples, dielectric fill 802 is the same dielectric material as mask layer 602 (e.g., silicon dioxide). A top surface of dielectric fill 802 may be polished using, for example, chemical mechanical polishing (CMP) such that it is substantially coplanar with a top surface of sacrificial gates 212.

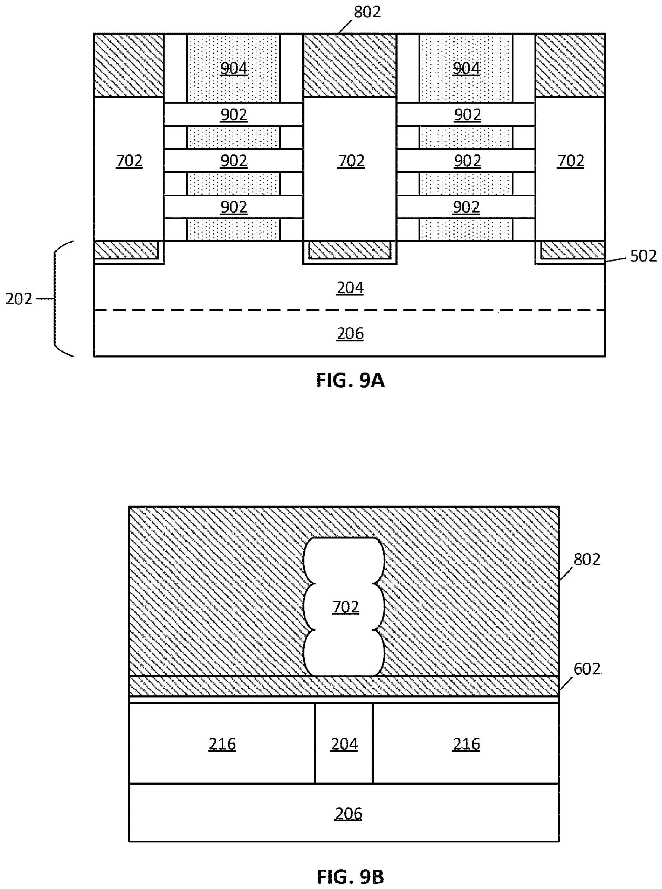

Figures 9A and 9B depict the cross-section views of the structure shown in Figures 8A and 8B, respectively, following the removal of sacrificial gates 212 and sacrificial layers 208, and the subsequent formation of gate structures 904 in the gate trenches. Sacrificial gates 212 may be removed using any wet or dry isotropic process thus exposing the alternating layer stack of the fins within the trenches left behind after the removal of sacrificial gates 212. Once sacrificial gates 212 are removed, sacrificial layers 208 may also be removed using a selective isotropic etching process that removes the material of sacrificial layers 208 but does not remove (or removes very little of) semiconductor layers 210. At this point, the suspended (sometimes called released) semiconductor layers 210 form nanoribbons 902 that extend between source or drain region 702 and another source or drain region on the opposite ends of nanoribbons 902.

As noted above, gate structures 904 include a gate dielectric and a gate electrode. The gate dielectric may be conformally deposited around nanoribbons 902 using any suitable deposition process, such as atomic layer deposition (ALD). The gate dielectric may include any suitable dielectric (such as silicon dioxide, and/or a high-k dielectric material). Examples of high-k dielectric materials include, for instance, hafnium oxide, hafnium silicon dioxide, lanthanum oxide, lanthanum aluminum oxide, zirconium oxide, zirconium silicon dioxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on nanoribbons 902, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary gate structure that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Dielectric fill 802 protects source or drain region 702 during the formation of gate structures 904.

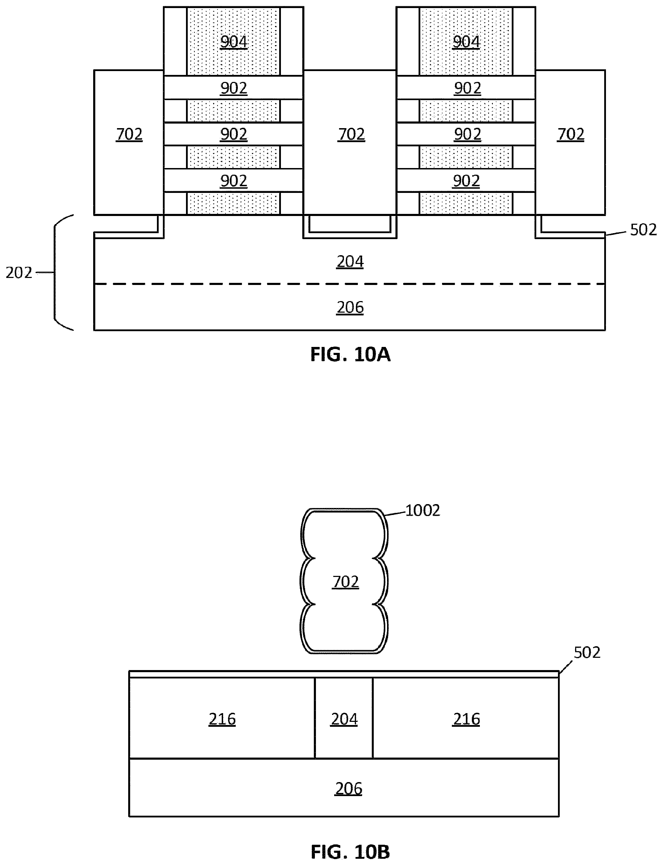

Figures 10A and 10B depict the cross-section views of the structure shown in Figures 9A and 9B, respectively, following the removal of dielectric fill 802 and mask layer 602, and the subsequent formation of conductive layer 1002 around source or drain region 702. According to some embodiments, both dielectric fill 802 and mask layer 602 may be removed using the same isotropic etching process (e.g., in examples where both dielectric fill 802 and mask layer 602 are silicon dioxide). Dielectric layer 502 may protect the underlying dielectric fill 216 from the isotropic etch, in some embodiments.

Conductive layer 1002 may be a silicide layer used to lower the contact resistance of source or drain region 702. In some embodiments, conductive layer 1002 extends around all outer surfaces of source or drain region 702. Conductive layer 1002 may be epitaxially grown such that it grows only on the exposed semiconductor surfaces of source or drain region 702. According to some embodiments, conductive layer 1002 may include one or more of TiSi, NiSi, NiPtSi, or CoSi, to name a few examples.

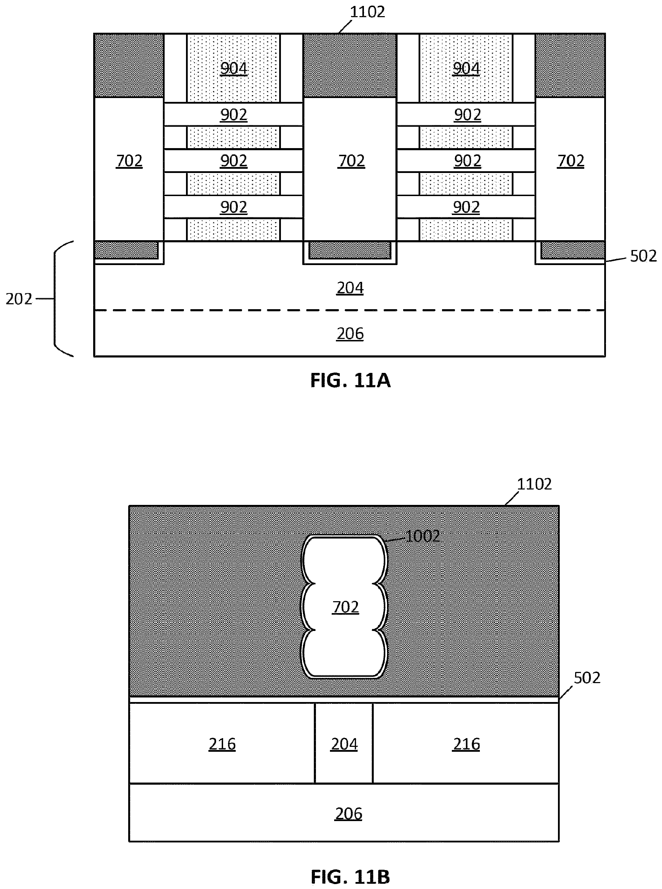

Figures 11A and 11B depict the cross-section views of the structure shown in Figures 10A and 10B, respectively, following the formation of conductive contact 1102 completely around source or drain region 702. According to some embodiments, conductive contact 1102 substantially fills the source/drain trench around any source or drain regions 702 along the trench. A top surface of conductive contact 1102 may be polished using, for example, CMP such that it is substantially coplanar with a top surface of gate structures 904. Dielectric layer 502 remains between conductive contact 1102 and the underlying dielectric fill 216 and subfin region 204, according to some embodiments.

Conductive contact 1102 may include any suitable conductive material such as tungsten (W). Other conductive materials may include copper (Cu), ruthenium (Ru), cobalt (Co), titanium (Ti), molybdenum (Mo), or any alloys thereof. In some embodiments, conductive contact 1102 includes a barrier layer that includes titanium or tantalum and a conductive fill on the barrier layer that includes any of the metals or metal alloys listed above. In some embodiments, conductive contact 1102 directly contacts conductive layer 1002 around source or drain region 702.

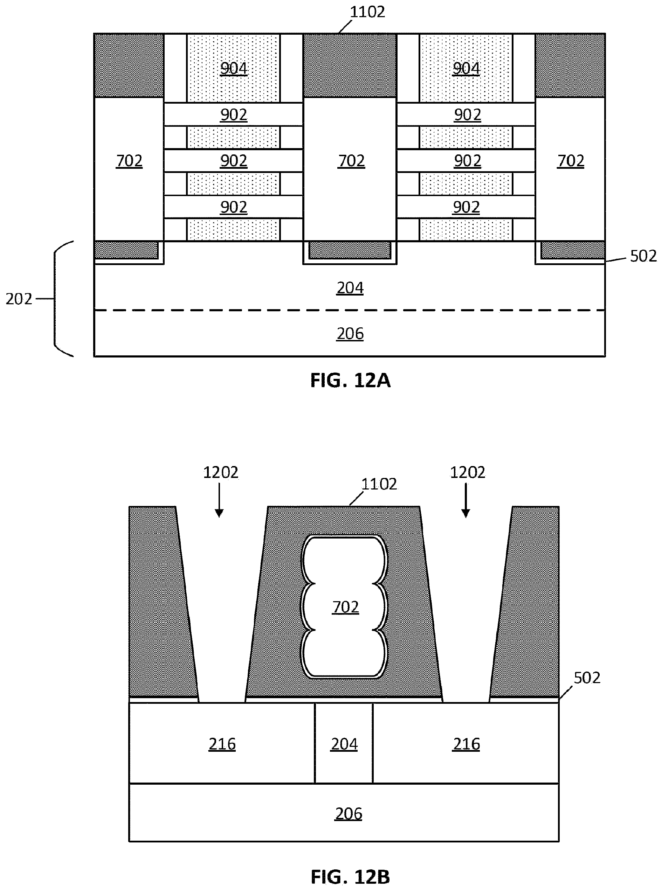

Figures 12A and 12B depict the cross-section views of the structure shown in Figures 11A and 11B, respectively, following the formation of plug recesses 1202 through at least an entire thickness of conductive contact 1102. According to some embodiments, an RIE process (or any other suitable anisotropic etching process) is used to form plug recesses 1202. In some examples, plug recesses 1202 extend through a portion of dielectric layer 502, such that some portion of dielectric layer 502 remains at the bottom of plug recesses 1202. In some other examples, plug recesses 1202 extend through an entire thickness of dielectric layer 502 and through a portion of dielectric fill 216.

Plug recesses 1202 may be formed to create a distinct conductive contact 1102 for source or drain region 702 that is electrically isolated from other contacts along the source/drain trench. According to some embodiments, plug recesses 1202 taper inwards as the etch progresses yielding recesses with a wider top compared to the bottom. This tapering process respectively yields a trapezoidal cross-section (inverse taper) for conductive contact 1102 along the second direction, according to some embodiments. Thus, for example, a top surface of conductive contact 1102 may have a smaller width in the second direction compared to a bottom surface of conductive contact 1102.

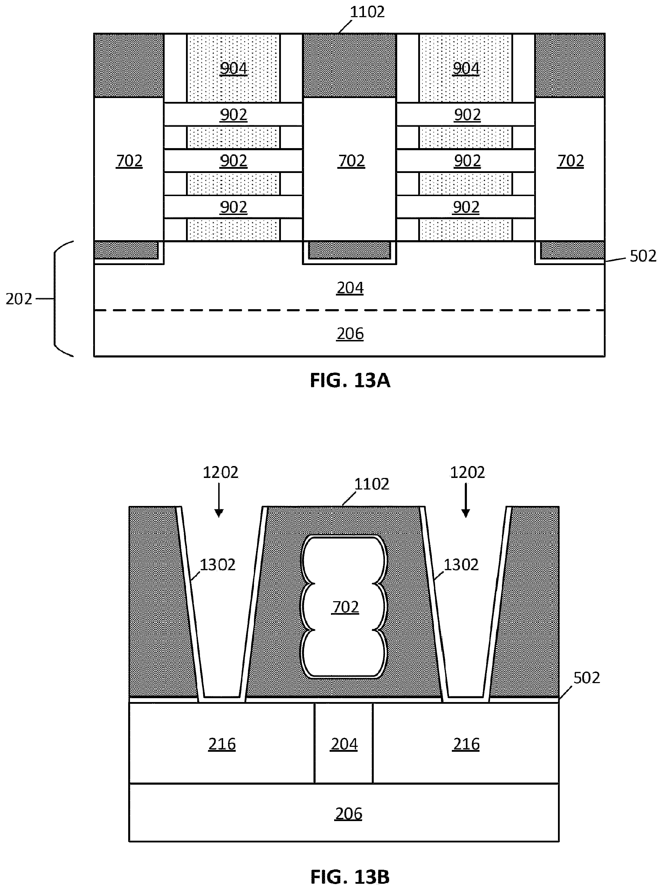

Figures 13A and 13B depict the cross-section views of the structure shown in Figures 12A and 12B, respectively, following the formation of a dielectric liner 1302 along the sidewalls of plug recesses 1202. According to some embodiments, dielectric liner 1302 is provided to protect conductive contact 1102 from potentially oxidizing materials used to fill the remaining volume of plug recesses 1202 (such as silicon dioxide). Dielectric liner 1302 may include silicon nitride. In some embodiments, dielectric liner 1302 has the same material composition as dielectric layer 502. Accordingly, a seam may or may not be observable between dielectric liner 1302 and dielectric layer 502.

Figures 14A and 14B depict the cross-section views of the structure shown in Figures 13A and 13B, respectively, following the formation of dielectric plug fill 1402 within a remaining volume of plug recesses 1202 and on dielectric liner 1302. As noted above, dielectric plug fill 1402 may be a low-k dielectric material, such as silicon dioxide, or any other suitable dielectric material. The formation of dielectric plug fill 1402 may complete the formation of dielectric plugs 1404 on either side of conductive contact 1102. In some embodiments, one or both of the illustrated dielectric plugs 1404 may not be present in situations, such as in situations where adjacent source or drain regions are desired to be electrically coupled together. As noted above, when discussing the etching of plug recesses 1202, one or both of the illustrated dielectric plugs 1404 may extend into at least a portion of the thickness of dielectric fill 216.

According to some embodiments, backside contacts may also be integrated with the wrapped conductive contact 1102 to provide power or signal routing to the backside of conductive contact 1102. Briefly, such backside contacts may be formed by etching through subfin region 204 (e.g., during the etching process illustrated in Figures 3A and 3B, or the processing illustrated in Figures 5A and 5B) and replacing subfin region 204 with a sacrificial material (e.g., place holder 505). After the wrapped conductive contact 1102 has been formed, bulk region 206 of the substrate can be removed and the sacrificial material can be replaced with a conductive material form the backside to form a backside contact 1405 that connects with the bottom surface of conductive contact 1102. Then a backside interconnect structure 1409 can be formed, which may include dielectric material and one or more conductive interconnect features that may directly or indirectly couple with backside contact 1405. In this example, a portion of dielectric layer 502 remains adjacent to a top surface of backside contact 1405, such that a portion of dielectric layer 502 is adjacent to each of source or drain region 702, the conductive contact 1102, and backside contact 1405.

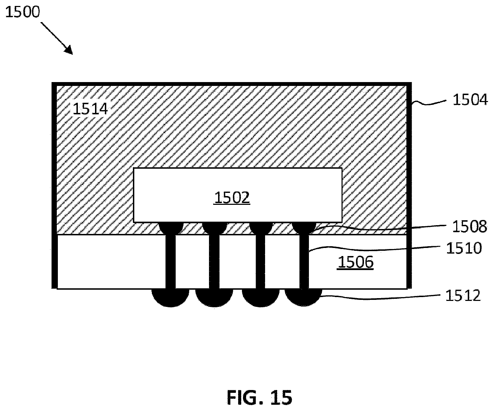

Figure 15 illustrates an example embodiment of a chip package 1500. As can be seen, chip package 1500 includes one or more dies 1502. One or more dies 1502 may include at least one integrated circuit having semiconductor devices, such as any of the semiconductor devices disclosed herein. One or more dies 1502 may include any other circuitry used to interface with other devices formed on the dies, or other devices connected to chip package 1500, in some example configurations.

As can be further seen, chip package 1500 includes a housing 1504 that is bonded to a package substrate 1506. The housing 1504 may be any standard or proprietary housing, and provides, for example, electromagnetic shielding and environmental protection for the components of chip package 1500. The one or more dies 1502 may be conductively coupled to a package substrate 1506 using connections 1508, which may be implemented with any number of standard or proprietary connection mechanisms, such as solder bumps, ball grid array (BGA), pins, or wire bonds, to name a few examples. Package substrate 1506 may be any standard or proprietary package substrate, but in some cases includes a dielectric material having conductive pathways (e.g., including conductive vias and lines) extending through the dielectric material between the faces of package substrate 1506, or between different locations on each face. In some embodiments, package substrate 1506 may have a thickness less than 1 millimeter (e.g., between 0.1 millimeters and 0.5 millimeters), although any number of package geometries can be used. Additional conductive contacts 1512 may be disposed at an opposite face of package substrate 1506 for conductively contacting, for instance, a printed circuit board (PCB). One or more vias 1510 extend through a thickness of package substrate 1506 to provide conductive pathways between one or more of connections 1508 to one or more of contacts 1512. Vias 1510 are illustrated as single straight columns through package substrate 1506 for ease of illustration, although other configurations can be used (e.g., damascene, dual damascene, through-silicon via). In still other embodiments, vias 1510 are fabricated by multiple smaller stacked vias, or are staggered at different locations across package substrate 1506. In the illustrated embodiment, contacts 1512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1512, to inhibit shorting.

In some embodiments, a mold material 1514 may be disposed around the one or more dies 1502 included within housing 1504 (e.g., between dies 1502 and package substrate 1506 as an underfill material, as well as between dies 1502 and housing 1504 as an overfill material). Although the dimensions and qualities of the mold material 1514 can vary from one embodiment to the next, in some embodiments, a thickness of mold material 1514 is less than 1 millimeter. Example materials that may be used for mold material 1514 include epoxy mold materials, as suitable. In some cases, the mold material 1514 is thermally conductive, in addition to being electrically insulating.

### Methodology

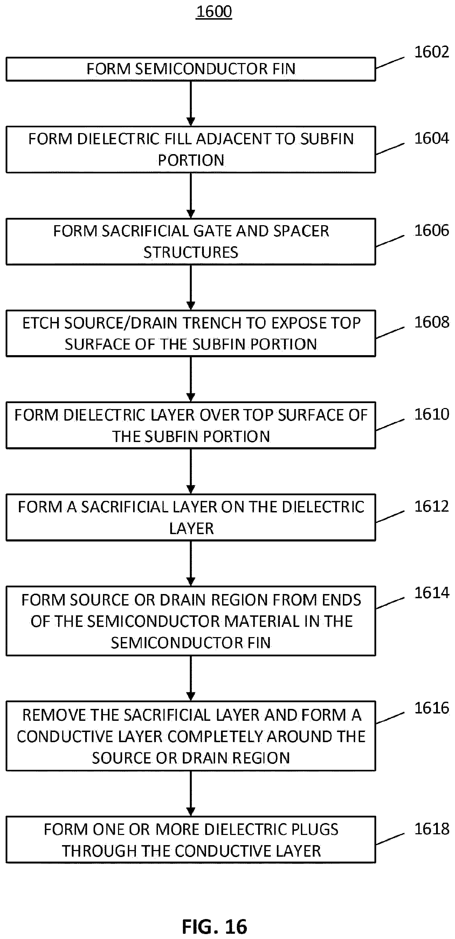

Figure 16 is a flow chart of a method 1600 for forming at least a portion of an integrated circuit, according to an embodiment. Various operations of method 1600 may be illustrated in Figures 2A - 14A and 2B - 14B. However, the correlation of the various operations of method 1600 to the specific components illustrated in the aforementioned figures is not intended to imply any structural and/or use limitations. Rather, the aforementioned figures provide one example embodiment of method 1600. Other operations may be performed before, during, or after any of the operations of method 1600. Some of the operations of method 1600 may be performed in a different order than the illustrated order.

Method 1600 begins with operation 1602 where at least one semiconductor fin is formed, according to some embodiments. The semiconductor material in the at least one fin may be formed from a substrate such that the fin is an integral part of the substrate (e.g., etched from a bulk silicon substrate). Alternatively, the fin can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around process can then be carried out. Again, the alternating layers can be blanket deposited and then etched into fins, or deposited into fin-shaped trenches.

Method 1600 continues with operation 1604 where a dielectric fill is formed adjacent to a subfin portion of the fin. The dielectric fill may include silicon dioxide. According to some embodiments, the dielectric fill acts as an STI region between the fin and any adjacent fins. According to some embodiments, each semiconductor device includes a subfin portion beneath a fin of alternating semiconductor layers and adjacent to the dielectric fill. The subfin may include the same material as a bulk region of the underlying semiconductor substrate.

Method 1600 continues with operation 1606 where sacrificial gates and sidewall spacers are formed over a portion of the fin. The sacrificial gates may include any material that can be safely removed later in the process without etching or otherwise damaging the sidewall spacers and/or the fin. The sacrificial gates may include polysilicon while the sidewall spacers may include silicon nitride. The sidewall spacers are formed on sidewalls of the sacrificial gates and etched back to remove the sidewall spacer material from any horizontal surfaces.

Method 1600 continues with operation 1608 where a source/drain trench is etched through the fin between adjacent sacrificial gates and sidewall spacers. An RIE process may be used to etch through the semiconductor material of the fin. The width of the sidewall spacers works to define the length of each fin that defines each semiconductor device. According to some embodiments, the fin is completely removed above the subfin portion. In some embodiments, the RIE process may also etch partially into the subfin thus recessing the subfin beneath a top surface of the adjacent dielectric fill.

Method 1600 continues with operation 1610 where a dielectric liner is formed over at least a top surface of the subfin portion within the source/drain trench. The dielectric liner may include a high-k dielectric material (e.g., having a dielectric constant greater than 6.5), such as silicon nitride. In some embodiments, the dielectric liner may include any dielectric material having a high etch selectivity compared to the dielectric material (e.g., silicon dioxide) of the dielectric fill. The dielectric liner may be deposited using ALD to a thickness between about 1 nm and about 5 nm.

Method 1600 continues with operation 1612 where a sacrificial layer is formed over the dielectric liner within the source/drain trench. According to some embodiments, the sacrificial layer may be deposited using a directional (e.g., non-conformal) technique such as PVD to form at the bottom of the source/drain trench and not along the sidewalls of the trench. The sacrificial layer may be any dielectric material or other hard mask material having a high etch selectively compared to the material of the underlying dielectric liner. For example, the sacrificial layer may be silicon dioxide while the dielectric liner is silicon nitride or vice-versa. Once the sacrificial layer has been deposited, the exposed portions of the dielectric liner (e.g., along the sidewalls of the source/drain trench) may be removed using any suitable isotropic etching process. The removal of the dielectric liner from the sidewalls may expose an end (or ends) of the semiconductor material in the semiconductor fin.

Method 1600 continues with operation 1614 where a source or drain region is formed from the end (or ends) of the semiconductor material in the semiconductor fin. The source or drain region may be epitaxially grown from the exposed ends of semiconductor layers from adjacent fins, such that the material grows together towards the middle of the source/drain trench between the fins. In the example of a PMOS device, the source or drain region may be a semiconductor material (e.g., group IV or group III-V semiconductor materials) having a higher dopant concentration of p-type dopants compared to n-type dopants. In the example of an NMOS device, the source or drain region may be a semiconductor material (e.g., group IV or group III-V semiconductor materials) having a higher dopant concentration of n-type dopants compared to p-type dopants. In some examples, the source or drain region forms directly on the underlying sacrificial layer. In some other examples, there is space between a bottom surface of the source or drain region and the top surface of the underlying sacrificial layer within the source/drain trench.

Method 1600 continues with operation 1616 where at least the sacrificial layer is removed and a conductive layer is formed completely around the source or drain region. The sacrificial layer may be removed along with one or more other dielectric layers using an isotropic etching process. According to some embodiments, the dielectric liner remains during the removal of the sacrificial layer to protect at least the underlying dielectric fill form the etching process. The conductive layer may include any suitable conductive material such as tungsten (W). Other conductive materials may include copper (Cu), ruthenium (Ru), cobalt (Co), titanium (Ti), molybdenum (Mo), or any alloys thereof. According to some embodiments, the conductive layer may substantially fill the source/drain trench such that it wraps around a plurality of source or drain regions along the source/drain trench. The conductive layer may be deposited using any deposition process such as CVD or PVD.

Method 1600 continues with operation 1618 where one or more dielectric plugs are formed through the conductive layer to electrically isolate different portions of the conductive layer along the source/drain trench. According to some embodiments the one or more dielectric plugs extend through an entire thickness of the conductive layer. The one or more dielectric plugs may include any suitable dielectric material. In one example, the one or more dielectric plugs include a dielectric liner that includes a high-k material (such as silicon nitride) and a dielectric fill that includes a low-k material (such as silicon dioxide). The one or more dielectric plugs may be provided to isolate the source or drain region and its corresponding wrapped conductive layer from any adjacent source or drain regions and may not be present in situations where adjacent source or drain regions are desired to be electrically coupled together.

### Example System

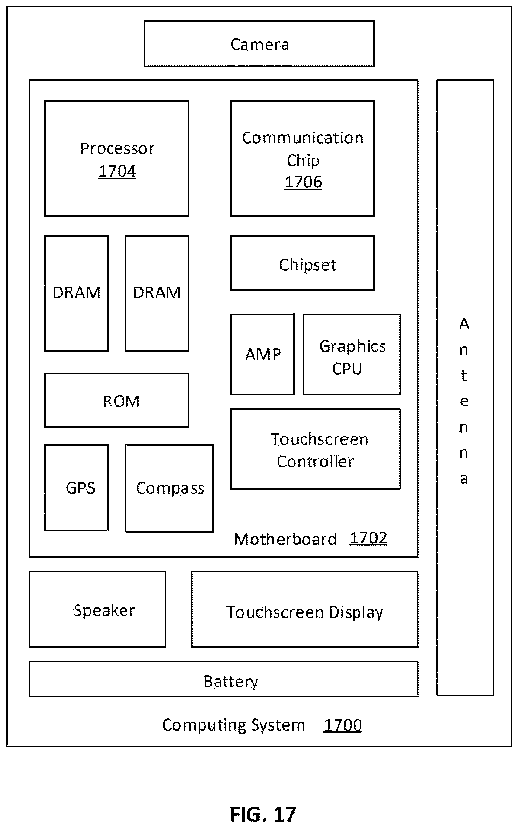

FIG. 17 is an example computing system implemented with one or more of the integrated circuit structures as disclosed herein, in accordance with some embodiments of the present disclosure. As can be seen, the computing system 1700 houses a motherboard 1702. The motherboard 1702 may include a number of components, including, but not limited to, a processor 1704 and at least one communication chip 1706, each of which can be physically and electrically coupled to the motherboard 1702, or otherwise integrated therein. As will be appreciated, the motherboard 1702 may be, for example, any printed circuit board (PCB), whether a main board, a daughterboard mounted on a main board, or the only board of system 1700, etc.

Depending on its applications, computing system 1700 may include one or more other components that may or may not be physically and electrically coupled to the motherboard 1702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1700 may include one or more integrated circuit structures or devices configured in accordance with an example embodiment (e.g., a module including an integrated circuit device on a substrate, the substrate having one or more semiconductor devices with source or drain regions with conductive contacts wrapped around the source or drain regions, as variously provided herein). In some embodiments, multiple functions can be integrated into one or more chips (e.g., for instance, note that the communication chip 1706 can be part of or otherwise integrated into the processor 1704).

The communication chip 1706 enables wireless communications for the transfer of data to and from the computing system 1700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1700 may include a plurality of communication chips 1706. For instance, a first communication chip 1706 may be dedicated to shorter range wireless communications such as Wi-Fi and Bluetooth and a second communication chip 1706 may be dedicated to longer range wireless communications such as GPS, EDGE, GPRS, CDMA, WiMAX, LTE, Ev-DO, and others.

The processor 1704 of the computing system 1700 includes an integrated circuit die packaged within the processor 1704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1706 also may include an integrated circuit die packaged within the communication chip 1706. In accordance with some such example embodiments, the integrated circuit die of the communication chip includes one or more semiconductor devices as variously described herein. As will be appreciated in light of this disclosure, note that multistandard wireless capability may be integrated directly into the processor 1704 (e.g., where functionality of any chips 1706 is integrated into processor 1704, rather than having separate communication chips). Further note that processor 1704 may be a chip set having such wireless capability. In short, any number of processor 1704 and/or communication chips 1706 can be used. Likewise, any one chip or chip set can have multiple functions integrated therein.

In various implementations, the computing system 1700 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.
Example 1 is an integrated circuit that includes a first semiconductor device having a subfin and one or more first semiconductor bodies extending in a first direction between a first source or drain region and a second source or drain region, a second semiconductor device having the subfin and one or more second semiconductor bodies extending in the first direction between the first source or drain region and a third source or drain region, a conductive layer that wraps around the first source or drain region between the one or more first semiconductor bodies and the one or more second semiconductor bodies, and a dielectric layer on a top surface of the subfin. The subfin extends beneath the conductive layer and the dielectric layer is between the subfin and the conductive layer.
Example 2 includes the integrated circuit of Example 1, wherein the one or more first semiconductor bodies and the one or more second semiconductor bodies are nanoribbons that comprise germanium, silicon, or any combination thereof.
Example 3 includes the integrated circuit of Example 1 or 2, further comprising a silicide layer around an outer surface of the first source or drain region.
Example 4 includes the integrated circuit of Example 3, wherein the silicide layer is directly between the first source or drain region and the conductive layer.
Example 5 includes the integrated circuit of any one of Examples 1-4, wherein the conductive layer extends in a second direction between the first source or drain region and a dielectric plug, the second direction being orthogonal to the first direction.
Example 6 includes the integrated circuit of Example 5, wherein the dielectric layer is a first dielectric layer and the integrated circuit further comprises a second dielectric layer along a sidewall of the dielectric plug such that the second dielectric layer is between the dielectric plug and the conductive layer.
Example 7 includes the integrated circuit of Example 6, wherein the first dielectric layer and the second dielectric layer comprise the same dielectric material.
Example 8 includes the integrated circuit of any one of Examples 1-7, wherein the conductive layer has a trapezoidal cross-section with a bottom surface of the conductive layer having a first width in a second direction and a top surface of the conductive layer having a second width in the second direction, the second direction being orthogonal to the first direction, and the first width being greater than the second width.
Example 9 includes the integrated circuit of any one of Examples 1-8, wherein the conductive layer comprises tungsten.
Example 10 includes the integrated circuit of any one of Examples 1-9, wherein the dielectric layer comprises silicon and nitrogen.
Example 11 is a printed circuit board comprising the integrated circuit of any one of Examples 1-10.
Example 12 is an electronic device that includes a chip package comprising one or more dies. At least one of the one or more dies includes a first semiconductor device having a subfin and one or more first semiconductor bodies extending in a first direction between a first source or drain region and a second source or drain region, a second semiconductor device having the subfin and one or more second semiconductor bodies extending in the first direction between the first source or drain region and a third source or drain region, a conductive layer that extends completely around the first source or drain region between the one or more first semiconductor nanoribbons and the one or more second semiconductor nanoribbons, and a dielectric layer on a top surface of the subfin. The subfin extends beneath the conductive layer and the dielectric layer is between the subfin and the conductive layer.
Example 13 includes the electronic device of Example 12, wherein the one or more first semiconductor nanoribbons and the one or more second semiconductor nanoribbons comprise germanium, silicon, or any combination thereof.
Example 14 includes the electronic device of Example 12 or 13, wherein the at least one of the one or more dies further comprises a silicide layer around an outer surface of the first source or drain region.
Example 15 includes the electronic device of Example 14, wherein the silicide layer is directly between the first source or drain region and the conductive layer.
Example 16 includes the electronic device of any one of Examples 12-15, wherein the conductive layer extends in a second direction between the first source or drain region and a dielectric plug, the second direction being orthogonal to the first direction.
Example 17 includes the electronic device of Example 16, wherein the dielectric layer is a first dielectric layer and the at least one of the one or more dies further comprises a second dielectric layer along a sidewall of the dielectric plug such that the second dielectric layer is between the dielectric plug and the conductive layer.
Example 18 includes the electronic device of Example 17, wherein the first dielectric layer and the second dielectric layer comprise the same dielectric material.
Example 19 includes the electronic device of any one of Examples 12-18, wherein the conductive layer has a trapezoidal cross-section with a bottom surface of the conductive layer having a first width in a second direction and a top surface of the conductive layer having a second width in the second direction, the second direction being orthogonal to the first direction, and the first width being greater than the second width.
Example 20 includes the electronic device of any one of Examples 12-19, wherein the conductive layer comprises tungsten.
Example 21 includes the electronic device of any one of Examples 12-20, wherein the dielectric layer comprises silicon and nitrogen.
Example 22 includes the electronic device of any one of Examples 12-21, further comprising a printed circuit board, wherein the chip package is attached to the printed circuit board.
Example 23 is a method of forming an integrated circuit. The method includes forming a multilayer fin extending in a first direction over a substrate having a first section with first material layers alternating with second material layers, and a subfin section beneath the first section; forming a dielectric fill adjacent to the subfin section; forming a sacrificial gate and spacers on sidewalls of the sacrificial gate, the sacrificial gate extending in a second direction over the multilayer fin, the second direction being different from the first direction; removing an exposed portion of the multilayer fin adjacent to the sacrificial gate, the removing exposing a top surface of the subfin; forming a dielectric layer on the top surface of the subfin and on a top surface of the adjacent dielectric fill; forming a sacrificial layer on the dielectric layer; forming a source or drain region over the sacrificial layer and coupled to ends of the second material layers; forming a sacrificial material around the source or drain region and over the sacrificial layer; removing the sacrificial gate and forming a gate structure over the first material layers; removing the sacrificial layer and the sacrificial material and forming a conductive layer completely around the source or drain region; and forming one or more dielectric plugs through an entire thickness of the conductive layer.
Example 24 includes the method of Example 23, wherein the first material layers comprise silicon and germanium and the second material layers comprise silicon.
Example 25 includes the method of Example 23 or 24, wherein the sacrificial layer and the sacrificial material are the same material.
Example 26 includes the method of Example 25, wherein the sacrificial layer and the sacrificial material both comprise silicon and oxygen.
Example 27 includes the method of any one of Examples 23-26, further comprising forming a silicide layer completely around an outer surface of the source or drain region.
Example 28 is an integrated circuit that includes a semiconductor device having a subfin and one or more semiconductor nanoribbons extending in a first direction from a source or drain region, a conductive layer that extends completely around the source or drain region, and a dielectric layer on a top surface of the subfin. The subfin extends beneath the conductive layer and at least a portion of the dielectric layer is between the subfin and the conductive layer.
Example 29 includes the integrated circuit of Example 28, wherein the one or more semiconductor nanoribbons comprise germanium, silicon, or any combination thereof.
Example 30 includes the integrated circuit of Example 28 or 29, further comprising a silicide layer around an outer surface of the source or drain region.
Example 31 includes the integrated circuit of Example 30, wherein the silicide layer is directly between the source or drain region and the conductive layer.
Example 32 includes the integrated circuit of any one of Examples 28-31, wherein the conductive layer extends in a second direction between the source or drain region and a dielectric plug, the second direction being orthogonal to the first direction.
Example 33 includes the integrated circuit of Example 32, wherein the dielectric layer is a first dielectric layer and the integrated circuit further comprises a second dielectric layer along a sidewall of the dielectric plug such that the second dielectric layer is between the dielectric plug and the conductive layer.
Example 34 includes the integrated circuit of Example 33, wherein the first dielectric layer and the second dielectric layer comprise the same dielectric material.
Example 35 includes the integrated circuit of any one of Examples 28-34, wherein the conductive layer has a trapezoidal cross-section with a bottom surface of the conductive layer having a first width in a second direction and a top surface of the conductive layer having a second width in the second direction, the second direction being orthogonal to the first direction, and the first width being greater than the second width.
Example 36 includes the integrated circuit of any one of Examples 28-35, wherein the conductive layer comprises tungsten.
Example 37 includes the integrated circuit of any one of Examples 28-36, wherein the dielectric layer comprises silicon and nitrogen.
Example 38 includes the integrated circuit of any one of Examples 28-37, further comprising: a backside contact below the source or drain region and coupled to a bottom surface of the conductive layer, wherein a portion of the dielectric layer is adj acent to each of the source or drain region, the conductive layer, and the backside contact.
Example 39 is a printed circuit board that includes the integrated circuit of any one of Examples 28-38.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a subfin and one or more first semiconductor bodies extending in a first direction between a first source or drain region and a second source or drain region;
a second semiconductor device having the subfin and one or more second semiconductor bodies extending in the first direction between the first source or drain region and a third source or drain region;
a conductive layer that wraps around the first source or drain region between the one or more first semiconductor bodies and the one or more second semiconductor bodies, wherein the subfin extends beneath the conductive layer; and
a dielectric layer on a top surface of the subfin, such that the dielectric layer is between the subfin and the conductive layer.

2. The integrated circuit of claim 1, wherein the one or more first semiconductor bodies and the one or more second semiconductor bodies are nanoribbons that comprise germanium, silicon, or any combination thereof.

3. The integrated circuit of claim 1 or 2, further comprising a silicide layer around an outer surface of the first source or drain region.

4. The integrated circuit of claim 3, wherein the silicide layer is directly between the first source or drain region and the conductive layer.

5. The integrated circuit of any one of claims 1 through 4, wherein the conductive layer extends in a second direction between the first source or drain region and a dielectric plug, the second direction being orthogonal to the first direction.

6. The integrated circuit of claim 5, wherein the dielectric layer is a first dielectric layer and the integrated circuit further comprises a second dielectric layer along a sidewall of the dielectric plug such that the second dielectric layer is between the dielectric plug and the conductive layer.

7. The integrated circuit of claim 6, wherein the first dielectric layer and the second dielectric layer comprise the same dielectric material.

8. The integrated circuit of any one of claims 1 through 7, wherein the conductive layer has a trapezoidal cross-section with a bottom surface of the conductive layer having a first width in a second direction and a top surface of the conductive layer having a second width in the second direction, the second direction being orthogonal to the first direction, and the first width being greater than the second width.

9. The integrated circuit of any one of claims 1 through 8, wherein the conductive layer comprises tungsten.

10. The integrated circuit of any one of claims 1 through 9, wherein the dielectric layer comprises silicon and nitrogen.

11. A printed circuit board comprising the integrated circuit of any one of claims 1 through 10.

12. A method of forming an integrated circuit, the method includes comprising:
forming a multilayer fin extending in a first direction over a substrate having a first section with first material layers alternating with second material layers, and a subfin section beneath the first section;
forming a dielectric fill adjacent to the subfin section;
forming a sacrificial gate and spacers on sidewalls of the sacrificial gate, the sacrificial gate extending in a second direction over the multilayer fin, the second direction being different from the first direction;
removing an exposed portion of the multilayer fin adjacent to the sacrificial gate, the removing exposing a top surface of the subfin;
forming a dielectric layer on the top surface of the subfin and on a top surface of the adjacent dielectric fill;
forming a sacrificial layer on the dielectric layer;
forming a source or drain region over the sacrificial layer and coupled to ends of the second material layers;
forming a sacrificial material around the source or drain region and over the sacrificial layer;
removing the sacrificial gate and forming a gate structure over the first material layers;
removing the sacrificial layer and the sacrificial material and forming a conductive layer completely around the source or drain region; and
forming one or more dielectric plugs through an entire thickness of the conductive layer.

13. The method of Example 12, wherein the first material layers comprise silicon and germanium and the second material layers comprise silicon.

14. The method of Example 12 or 13, wherein the sacrificial layer and the sacrificial material are the same material.

15. The method of any one of claims 12 through 14, further comprising forming a silicide layer completely around an outer surface of the source or drain region.
